# EUROPEAN PATENT APPLICATION

(11) **EP 4 496 223 A1**
(43) Date of publication of application: **22.01.2025**
(21) Application number: 23186180.8
(22) Date of filing: 18.07.2023
(51) Int. Cl.: H03K 17/18, E05B 81/64

(54) **VEHICLE DOOR LATCH AND METHOD FOR DIAGNOSING A SWITCH OF A VEHICLE DOOR LATCH**

(71) Applicant: Kiekert AG, 42579 Heiligenhaus (DE)
(72) Inventor: MERLETTI, Marco, 21045 Gazzada Schianno (Varese) (IT)
(74) Representative: Michalski Hüttermann & Partner Patentanwälte mbB

(57) **Abstract**

The invention relates to a vehicle door latch (1) for locking a door (3) of a motor vehicle (2), comprising a diagnosable switch (4) comprising a parallel resistor (6), a switch (7) configured for determining a position of the door (3) and a series resistor (8), whereby the parallel resistor (6) is connected in parallel to the switch (7) and in series with the series resistor (8), and a diagnosis circuit (5) comprising a diode (10), a pull up resistor (11) configured for receiving a pull up voltage from a power source (16), a voltage divider (12) comprising a midpoint (13) and a microcontroller (14), whereby the diode (10) is connected between the series resistor (8) and the voltage divider (12), the midpoint (13) is connected to the microcontroller (14), an anode of the diode (10) facing the voltage divider (12) is connected to the pull up resistor (11) and the microcontroller (14) is configured for determining if a midpoint voltage of the midpoint (13) correlates to a switching position of the switch (7).

## Description

### Technical Field

The invention relates to a vehicle door latch for locking a door of a motor vehicle, comprising a diagnosable switch comprising a parallel resistor, a switch configured for determining a position of the door and a series resistor, whereby the parallel resistor is connected in parallel to the switch and in series with the series resistor. The invention further relates to a method for diagnosing a switch of a vehicle door latch for locking a door of a motor vehicle, whereby the vehicle door latch comprises a diagnosable switch comprising a parallel resistor, the switch configured for determining a position of the door and a series resistor, whereby the parallel resistor is connected in parallel to the switch and in series with the series resistor.

### Background Art

Switches are commonly used in automotive latch application to sense position for specific applications. Commonly used positions are 'primary' to identify a vehicle door closed, 'open' to identify the vehicle door open and 'secondary' to identify an intermediate position close to 'primary'.

For such kind of switches there are some safety aspects that require deep diagnostics with special circuits and methods in order to grant continuous diagnostic both in normal operation mode and in power save mode.

Regarding the circuits, diagnosable switches, for example with inner parallel and series resistor, are often used. However, circuits and respective methods known from prior art often do not satisfy safety aspects in particular in respect to power safe modes.

### Summary of invention

It is therefore an object of the invention to provide an easy, cheap and/or reliable solution for an improved solution for diagnosing a switch in a vehicle door latch.

The object of the invention is solved by the features of the independent claims. Preferred implementations are detailed in the dependent claims.

Thus, the object is solved by a vehicle door latch for locking a door of a motor vehicle, comprising
a diagnosable switch comprising a parallel resistor, a switch configured for determining a position of the door and a series resistor, whereby the parallel resistor is connected in parallel to the switch and in series with the series resistor, and
a diagnosis circuit comprising a diode, a pull up resistor configured for receiving a pull up voltage from a power source, a voltage divider comprising a midpoint and a microcontroller, whereby the diode is connected between the series resistor and the voltage divider, the midpoint is connected to the microcontroller, an anode of the diode facing the voltage divider is connected to the pull up resistor and the microcontroller is configured for determining if a midpoint voltage of the midpoint correlates to a switching position of the switch.

The proposed vehicle door latch and a respective method described below provide a simple and reliable solution for continuous diagnostic of the switch during normal operation and during power safe modes, in particular for performing a diagnostic routine in respect to the switch, the diagnosable switch and/or the vehicle door latch. With the proposed diagnosis circuit it is possible to detect open load, short to battery and short to ground failures of the switch respectively of the diagnosable switch. For example, during an open condition, the diode insulates the diagnosis circuit from the diagnosable switch and allows an external device, for example by an advanced driver assisted system, ADAS, device, connection by means of the pull up voltage.

The power source can be a main power source of the motor vehicle, which is preferably provided as a battery of the motor vehicle for example delivering 12 or 24 V DC. The vehicle door latch preferably comprises an electric motor configured for actuating the vehicle door latch in respect to locking and unlocking a door of the motor vehicle. More generally, the expression "vehicle door latch" should be understood as a means for locking a movable element between an open position and a closed position, thereby opening and closing an access to an inner compartment of a motor vehicle, for example including, boot, rear hatches, bonnet lid or other closed compartments, window regulators, sunroofs, in addition to the side doors of a motor vehicle.

The vehicle can be provided as an electrical vehicle. The vehicle door latch may comprise a housing, made of metal, plastics or a combination thereof. In particular the electric motor, the diagnosable switch and the diagnosis circuit are preferably provided within the housing. Besides that the diagnosable switch and the diagnosis circuit can be provided within an electronic housing arranged within the housing and/or within the vehicle door latch.

According to a preferred implementation, the microcontroller is provided as a system basic chip, as a microprocessor and/or can be part of an electronic control unit, ECU, of the vehicle door latch and/or of the motor vehicle. The system basic chip is preferably provided as an integrated circuit that includes various functions of automotive electronic control units, ECU, on a single die. The system basic chip and/or the microcontroller may include embedded functions such as voltage regulators, supervision functions, reset generators, watchdog functions, bus interfaces, such as for example Local Interconnect Network, LIN, CAN bus or others, wake-up logic and/or power switches. The microcontroller preferably comprises an analog input peripheral, such as for example an analog digital converter, ADC, connected to the midpoint. The term "connected" should preferably be understood as electrically connected.

The switch respectively the diagnosable switch is preferably operatively and/or mechanically connected to the door for such wise determining the position of the door. The position can be, for example, closed ('primary'), open ('open') and/or an intermediate position closed to the closed position ('intermediate'). The diode can be provided as any diode known from prior art that allows conducting current primarily in one direction. The pull up resistor is preferably connected to the power source. The diode is preferably connected with its cathode to one end of the series resistor, while another end of the series resistor is connected to the parallel resistor. Determining if the midpoint voltage of the midpoint correlates to the switching position of the switch means in particular checking if the switching position matches a respective and/or estimated voltage of the midpoint voltage. For example, if the midpoint voltage is zero there is a failure (e.g. short to ground), if the midpoint voltage equals a voltage of the power source there is also a failure (e.g. short to power source), if the midpoint voltage is closer to a low value threshold (e.g. 1 V) the determined position is valid, if the midpoint voltage is closer to a high value threshold (e.g. 3 V) the determined position is valid and if the the midpoint voltage is closer to an open load voltage threshold (e.g. 2 V) there is a failure as well.

According to a preferred implementation, the parallel resistor, the switch and/or the voltage divider are connected in particular with one end to ground. Preferably, another end of the switch and of the parallel resistor are connected together. The voltage divider preferably comprises two resistors connected in series, whereby the midpoint is provided at a connection point of the two resistors.

In another preferred implementation, the vehicle door latch, in particular the diagnosis circuit, comprises a filter capacitor connected to the midpoint and preferably to ground. In particular, one end of the filter capacitor is connected to the midpoint while another end is connected to ground. The filter capacitor is preferably configured to filter out low amounts of frequencies.

According to another preferred implementation, the vehicle door latch, in particular the diagnosis circuit, comprises a pull up switch connected to, in particular to one end of the pull up resistor and is configured for receiving the pull up voltage from the power source, whereby the microcontroller is configured for switching the pull up switch. The pull up switch can be provided as an electronic switch, for example a transistor or a MOSFET. In another preferred implementation, the microcontroller is configured for determining if the pull up voltage of the midpoint correlates to the switching position of the switch in particular only when the pull up switch is switched on. Preferably, the voltage receivable by the pull up resistor is switched by the microprocessor using a polling pulse method, for example by means of periodical pulses with very low duty cycles. In this respect the microcontroller preferably reads the midpoint voltage preferably only when the pulse is active. Said midpoint voltage is preferably checked against the switching status before any action in respect to the door position is initiated.

According to another preferred implementation, the microprocessor is configured for periodically and/or continuously switching the voltage receivable by the pull up resistor. Preferably, the microprocessor is configured for periodically and/or continuously determining if the midpoint voltage of the midpoint correlates to the switching position of the switch.

In another preferred implementation, the microcontroller is configured, if the midpoint voltage does not correlate to the switching position, for issuing a failure signal. If such failure in respect to the failure signal is noticed, the microcontroller can notify the failure on a bus interface, such for example via a CAN or LIN interface such that internal and/or external safety actions can be evaluated and dangerous conditions avoided. Alternatively or in addition, the failure signal can be issued towards an electronic control unit, ECU, of the vehicle.

According to another preferred implementation, the microcontroller comprises a power-safe mode with a respective wake-up function and the microcontroller is configured, after wakening up to determine if the midpoint voltage of the midpoint correlates to the switching position of the switch. During such power-safe mode energy consumption of the microcontroller compared to a normal operating mode is reduced, for example by 50, 70, 90 or 100%. The wake-up function can be triggered, among others, by an internal handle trigger. In such case when an action is required the proposed diagnostic routine can be performed and only safe actions can be performed. Before the microcontroller goes into power save mode the diagnostic routine can be re-performed. Such wise additional power consumption can be avoided due to periodical wakeup for diagnostics purpose only, since during the power save mode the vehicle battery might be lost and/or other bus device cannot operate on a main bus interface, for example via a CAN and/or LIN bus.

The object is even further solved by a motor vehicle comprising a vehicle door latch as described before and a battery as power source.

The object is even further solved by a method for diagnosing a switch of a vehicle door latch for locking a door of a motor vehicle, whereby the vehicle door latch comprises
a diagnosable switch comprising a parallel resistor, the switch configured for determining a position of the door and a series resistor, whereby the parallel resistor is connected in parallel to the switch and in series with the series resistor, and
a diagnosis circuit comprising a diode, a pull up resistor configured for receiving a pull up voltage from a power source and a voltage divider comprising a midpoint, whereby the diode is connected between the series resistor and the voltage divider and an anode of the diode facing the voltage divider is connected to the pull up resistor, and comprising the step of:
   Determining if a midpoint voltage of the midpoint correlates to a switching position of the switch.

According to a preferred implementation, the vehicle door latch comprises a pull up switch connected to the pull up resistor and configured for receiving the pull up voltage from the power source, and comprising the step of:
Switching the pull up switch.

In another preferred implementation, the method comprises the step:
Determining if the midpoint voltage of the midpoint correlates to the switching position of the switch when the pull up switch is switched on.

According to a further preferred implementation, the method comprises the step:
Periodically and/or continuously switching the voltage receivable by the pull up resistor.

In another preferred implementation, the method comprises the step:
If the midpoint voltage does not correlate to the switching position, issuing a failure signal.

According to a further preferred implementation, in particular the diagnosis circuit comprises a microprocessor connected to the midpoint, whereby the microcontroller comprises a power-safe mode with a respective wake-up function, and comprising the step:
After wakening up the microprocessor, determining if the midpoint voltage of the midpoint correlates to the switching position of the switch.

Further implementations and advantages of the method can be derived by the person skilled in the art from the vehicle door latch as described above.

### Brief description of drawings

These and other aspects of the invention will be apparent from and elucidated with reference to the implementation described hereinafter.

In the drawings:

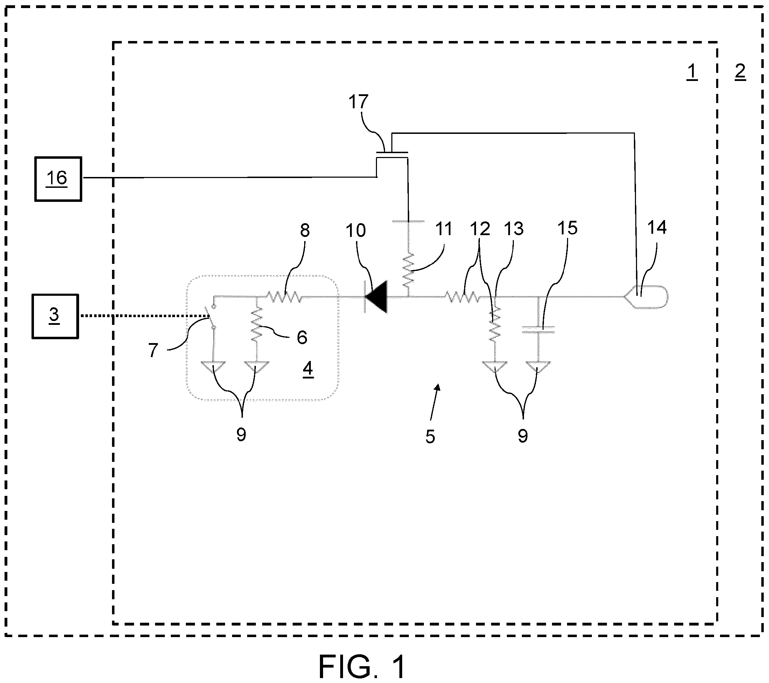

Fig. 1 shows a schematic circuit diagram comprising a diagnosable switch and diagnosis circuit of a vehicle door latch according to a preferred implementation.

### Description of implementations

Fig. 1 shows a schematic circuit diagram with an only schematically depicted vehicle door latch 1 for locking a door of an only schematically depicted motor vehicle 2. The motor vehicle 2 includes four side doors, of which one door 3 is schematically indicated in Fig. 1, which are each equipped with one vehicle door latch 1. Besides that the vehicle door latch 1 can be associated to rear hatches, bonnet lid or other closed compartments, window regulators, sunroofs, in addition to the side doors 3 of such motor vehicle 2.

The vehicle door latch 1 comprises a housing made of plastic, metal or a combination thereof. The housing houses arranged therein, in particular within a separate electronic housing, not shown, a diagnosable switch 4 and a diagnosis circuit 5.

The diagnosable switch 4 comprises a parallel resistor 6, a switch 7 configured for determining a position of the door 3 and a series resistor 8. The parallel resistor 6 and the switch 7 are connected in parallel with one end to ground 9. Another end connects the series resistor 8 such that the parallel resistor 6 and the series resistor 8 are connected in parallel. The switch 7 is provided as a mechanical switch operatively connected to the door 3.

The diagnosis circuit 5 comprises a diode 10, a pull up resistor 11, voltage divider 12 comprising a midpoint 13 and a microcontroller 14, and optionally a filter capacitor 15. The diode 10 is connected with its cathode to another end of series resistor 8 such that the series resistor 8 is connected in between the cathode and the parallel resistor 6. An anode of the diode 10 is connected to the pull up resistor 11 and one end of the voltage divider 12.

The voltage divider 12 comprises two resistors connected in the in series thereby forming the midpoint 13 between the two resistors. Another end of the voltage divider 12 is connected to ground 9. The filter capacitor 15 is connected between the midpoint 13 and ground 9 i.e. parallel to one of the two resistors of the voltage divider 12. The microcontroller 14 comprises an analog input peripheral, such as an analog digital converter, ADC, input connected to the midpoint 13.

The motor vehicle 2 comprises a main power source 16 provided as standard vehicle battery known from prior art and delivering a main supply voltage of 12 V DC. Said main supply voltage is supplied via a pull up switch 17 to another end of the pull up resistor 11. The electronically provided pull up switch 17 is switched by the microcontroller 14, in particular via a digital analog converter output of the microcontroller 14.

With such diagnosis circuit 5 it is possible to detect open load, short to battery i.e. short to main power source 16 and short to ground 9 failures. The diode 10 therefore insulates the diagnosis circuit 5 in open conditions of the switch 7 and allows external device connections. During a test routine action the main supply voltage of the main power source 16 is supplied via the pull up switch 17 operated by the microcontroller 14 to the such wise voltage controlled pull up resistor 11 and in turn to the midpoint 13. The microcontroller 14 can such wise determine if a midpoint voltage of the midpoint 13 correlates to a switching position of the switch 7.

A voltage supplied by the pull up switch 17 to the pull up resistor 11 is periodically controlled by the microcontroller 14 as per a polling pulse method. When a pulse is active, the microcontroller 14 reads an analog value from the midpoint 13 and discriminate if the value is acceptable before performing any action such confirming a status of the switch 7 to, for example, a control unit of the motor vehicle 2. The microcontroller 14 is therefore provided as a SBC, system basic chip.

During normal operating mode of the door 3 diagnostics provided by the diagnosable switch 4 and the diagnosis circuit 5 is continuous: If a failure of the switch 7 is noticed, said failure will be notified on a bus interface of the microcontroller 14, for example provided as CAN or LIN, such that internal safety actions of the motor vehicle 2 can be evaluated and dangerous conditions for the motor vehicle 2 respectively the door 3 can be avoided.

The microcontroller 14 comprises a power-safe mode with a respective wake-up function, whereby the microcontroller 14 determines, after being wakening up, if the midpoint voltage of the midpoint 13 correlates to the switching position of the switch 7. During such power save mode it is desired to reduce power consumption. Thus, said diagnostic routine is performed when an action is required, as for example an internal handle trigger. In such case only safe actions are performed, before which the microcontroller 14 is put into said power save mode for re-performing before described diagnostic routine. The method thereby avoids additional power consumption due to periodical wakeup for diagnostics purpose only, since during power save mode the main power source 16 is loss and other bus device cannot operate on the bus interface.

While the invention has been illustrated and described in detail in the drawings and foregoing description, such illustration and description are to be considered illustrative or exemplary and not restrictive; the invention is not limited to the dis-closed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference numerals

- 1: vehicle door latch
- 2: motor vehicle
- 3: door
- 4: diagnosable switch
- 5: diagnosis circuit
- 6: parallel resistor
- 7: switch
- 8: series resistor
- 9: ground
- 10: diode
- 11: pull up resistor
- 12: voltage divider
- 13: midpoint
- 14: microcontroller
- 15: filter capacitor
- 16: power source
- 17: pull up switch

## Claims

1. Vehicle door latch (1) for locking a door (3) of a motor vehicle (2), comprising
a diagnosable switch (4) comprising a parallel resistor (6), a switch (7) configured for determining a position of the door (3) and a series resistor (8), whereby the parallel resistor (6) is connected in parallel to the switch (7) and in series with the series resistor (8), and
a diagnosis circuit (5) comprising a diode (10), a pull up resistor (11) configured for receiving a pull up voltage from a power source (16), a voltage divider (12) comprising a midpoint (13) and a microcontroller (14), whereby the diode (10) is connected between the series resistor (8) and the voltage divider (12), the midpoint (13) is connected to the microcontroller (14), an anode of the diode (10) facing the voltage divider (12) is connected to the pull up resistor (11) and the microcontroller (14) is configured for determining if a midpoint voltage of the midpoint (13) correlates to a switching position of the switch (7).

2. Vehicle door latch (1) according to the previous claim, whereby the switch (7), the parallel resistor (6) and the voltage divider (12) are connected to ground (9).

3. Vehicle door latch (1) according to any of the previous claims, comprising a filter capacitor (15) connected to the midpoint (13) and preferably to ground (9).

4. Vehicle door latch (1) according to any of the previous claims, comprising a pull up switch (17) connected to the pull up resistor (11) and configured for receiving the pull up voltage from the power source (16), whereby the microcontroller (14) is configured for switching the pull up switch (17).

5. Vehicle door latch (1) according to the previous claim, whereby the microcontroller (14) is configured for determining if the pull up voltage of the midpoint (13) correlates to the switching position of the switch (7) when the pull up switch (17) is switched on.

6. Vehicle door latch (1) according to any of the previous claims, whereby the microcontroller (14) is configured for periodically and/or continuously switching the voltage receivable by the pull up resistor (11).

7. Vehicle door latch (1) according to any of the previous claims, whereby the microcontroller (14) is configured, if the midpoint voltage does not correlate to the switching position, for issuing a failure signal.

8. Vehicle door latch (1) according to any of the previous claims, whereby the microcontroller (14) comprises a power-safe mode with a respective wake-up function and the microcontroller (14) is configured, after wakening up to determine if the midpoint voltage of the midpoint (13) correlates to the switching position of the switch (7).

9. Motor vehicle (2) comprising a vehicle door latch (1) according to any of the previous claims and a battery as power source (16).

10. Method for diagnosing a switch (7) of a vehicle door latch (1) for locking a door (3) of a motor vehicle (2), whereby the vehicle door latch (1) comprises
a diagnosable switch (4) comprising a parallel resistor (6), the switch (7) configured for determining a position of the door (3) and a series resistor (8), whereby the parallel resistor (6) is connected in parallel to the switch (7) and in series with the series resistor (8), and
a diagnosis circuit (5) comprising a diode (10), a pull up resistor (11) configured for receiving a pull up voltage from a power source (16) and a voltage divider (12) comprising a midpoint (13), whereby the diode (10) is connected between the series resistor (8) and the voltage divider (12) and an anode of the diode (10) facing the voltage divider (12) is connected to the pull up resistor (11), and comprising the step of:
Determining if a midpoint voltage of the midpoint (13) correlates to a switching position of the switch (7) .

11. Method according to the previous method claim, whereby the vehicle door latch (1) comprises a pull up switch (17) connected to the pull up resistor (11) and configured for receiving the pull up voltage from the power source (16), and comprising the step of:
Switching the pull up switch (17).

12. Method according to any of the previous method claims, comprising the step of:
Determining if the midpoint voltage of the midpoint (13) correlates to the switching position of the switch (7) when the pull up switch (17) is switched on.

13. Method according to any of the previous method claims, comprising the step:
Periodically and/or continuously switching the voltage receivable by the pull up resistor (11).

14. Method according to any of the previous method claims, comprising the step:
If the midpoint voltage does not correlate to the switching position, issuing a failure signal.

15. Method according to any of the previous method claims, comprising a microcontroller (14) connected to the midpoint (13), whereby the microcontroller (14) comprises a power-safe mode with a respective wake-up function, and comprising the step:
After wakening up the microcontroller (14), determining if the midpoint voltage of the midpoint (13) correlates to the switching position of the switch (7).
